(19) Europäisches Patentamt
European Patent Office
Office européen des brevets

(11) Publication number: **0 382 233 B1**

(12) **EUROPEAN PATENT SPECIFICATION**

(45) Date of publication of patent specification: **10.08.94**  (51) Int. Cl.⁵: **H03K 5/05**

(21) Application number: **90102565.0**

(22) Date of filing: **09.02.90**

(54) Clock signal conversion circuit.

(30) Priority: **09.02.89 JP 30433/89**

(43) Date of publication of application:
**16.08.90 Bulletin 90/33**

(45) Publication of the grant of the patent:
**10.08.94 Bulletin 94/32**

(84) Designated Contracting States:
**FR**

(56) References cited:
**US-A- 4 031 476**

**ELECTRONIC ENGINEERING, vol. 49, no. 587, January 1977, page 25; "Pulse subtractor for frequency synthesis"**

**PATENT ABSTRACTS OF JAPAN, vol. 6, no. 115 (E-115)[993], 26th June 1982; & JP-A-57 44 326 (ANRITSU DENKI K.K.) 12-03-1982**

**INSTRUMENTS AND EXPERIMENTAL TECHNIOUES, vol. 18, no. 2, pt: 1, March/April 1975, pages 445-447, Plenum Publishing Corp.; N.A. KORNEV: "Time locking circuits"**

**U.Tietze, Ch.Schenk, "Halbleiter-Schaltungstechnik", 5th edition, Springer Verlag Berlin**

**Heidelberg New York 1980, pages 147 and 148**

(73) Proprietor: **FUJITSU LIMITED**
**1015, Kamikodanaka**
**Nakahara-ku**
**Kawasaki-shi Kanagawa 211(JP)**

(72) Inventor: **Matsuoka, Takeru, c/o Fujitsu Limited**
**Patent Department,**
**1015 Kamikodanaka**
**Nakahara-ku, Kawasaki-shi, Kanagawa 211(JP)**

(74) Representative: **Sunderland, James Harry et al**
**HASELTINE LAKE & CO**
**Hazlitt House**
**28 Southampton Buildings**
**Chancery Lane**
**London WC2A 1AT (GB)**

## Description

The present invention relates in general to a clock signal conversion circuit, and in particular to a clock signal conversion circuit that converts an external clock signal to an internal clock signal having a desired frequency.

In general, in a digital system, each of the system assemblies is timed with the aid of a clock signal. Since such a clock signal is common to the system then, for example when clock signals of different frequencies are required for different system assemblies, different internal clock signals are produced from the common clock signal for each system assembly. For this purpose, clock signal conversion circuits are employed.

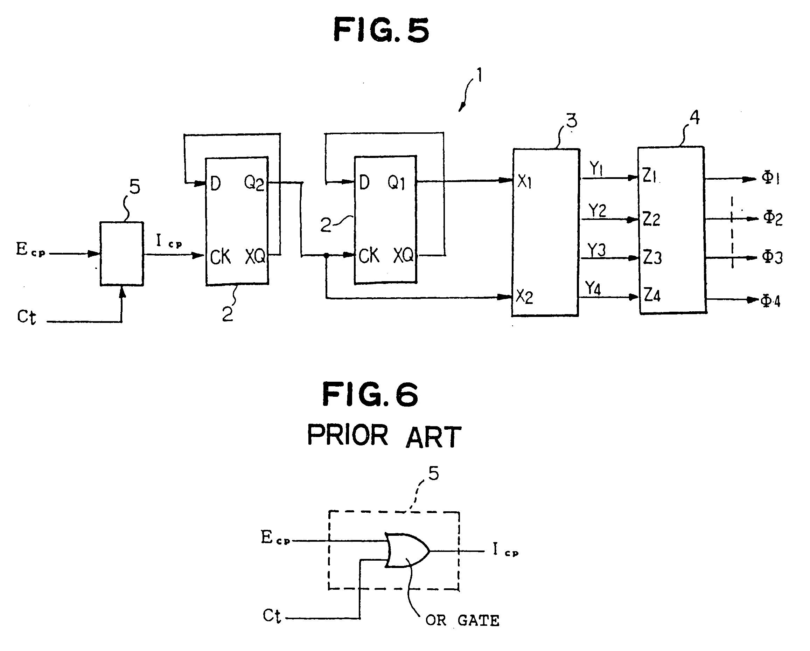

Fig. 5 of the accompanying drawing is a schematic block diagram illustrating a pulse motor controller 1 in which a conventional clock signal conversion circuit is employed. The pulse motor controller 1 includes asynchronous counters 2, a decoder 3, a drive current output circuit 4 and a clock signal conversion circuit 5. The frequency of an external clock signal Ecp is varied according to a control signal Ct to produce an internal clock signal Icp. The internal clock signal Icp is input to the asynchronous counters 2, and according to the logic of the terminals Q1 and Q2 of the counters 2, the decoder 3 outputs signals Y1, Y2, Y3 and Y4. In response to these signals Y1, Y2, Y3 and Y4, the drive current output circuit 4 produces polyphase power pulses $\Phi1$, $\Phi2$, $\Phi3$ and $\Phi4$, which pulses are then supplied to the exciting coils of a pulse or stepping motor (not shown).

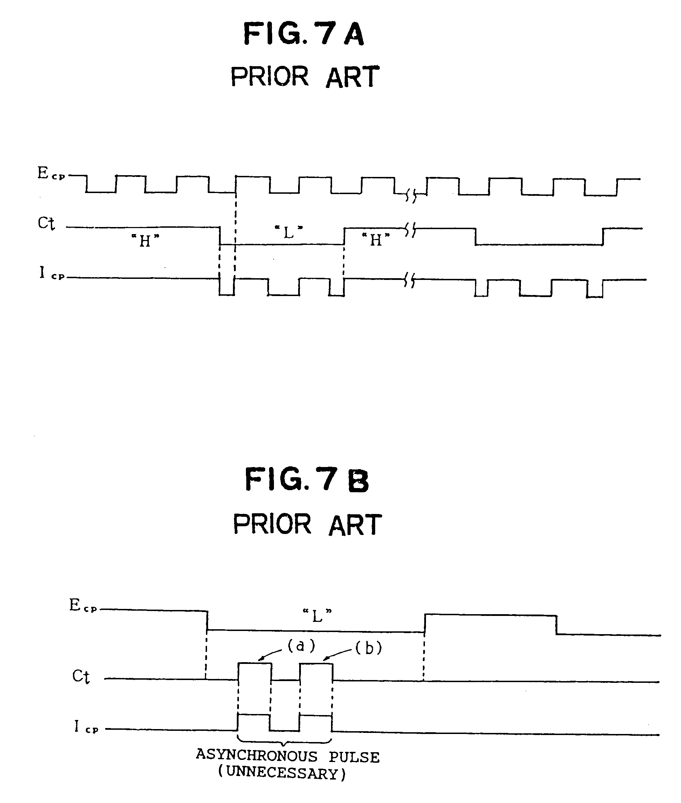

The above-described clock signal conversion circuit 5 is constituted by an OR gate, as shown schematically in Fig. 6. The internal clock signal Icp output from the OR gate becomes Icp = "H" while the control signal Ct is at "H" level, and becomes Ecp = Icp while the control signal Ct is at "L" level. That is to say, as shown in the timing diagram of Fig. 7A, by suitably setting the period of "L" level of the control signal Ct and the cycle (time) of Ct, an internal clock signal Icp can be produced which is synchronised with the external clock signal Ecp and has the requisite frequency.

The above-described conventional clock signal conversion circuit 5 is constructed such that the internal clock signal Icp is produced by OR logic between the external clock signal Ecp and the control signal Ct. Therefore, if, as shown in the timing diagram of Fig. 7(b), changes in the control signal Ct (for example, asynchronous pulses (a) and (b)) occur in a period when Ecp = "L", there is a problem in that pulses (a) and (b) appear in the internal clock signal Icp and may cause errors in subsequent circuits using the internal clock signal Icp. This is a problem that can be expected when the cycle of the external clock signal Ecp is long, so that the "L" level period is long. In addition, since the above-described asynchronous pulses (a) and (b) tend to be generated by external noise, such as power source noise, the effects of the problem described can be significant. Therefore, when the conventional clock signal conversion circuit is used, it is required that the "L" level period of the external clock signal Ecp not be too long. Consequently, the conventional clock signal conversion circuit is difficult to use.

Electronic Engineering, January 1977, page 25, in an article entitled "Pulse subtractor for frequency analysis", discloses circuitry for removing a pulse from an original pulse train, in response to a "remove a pulse" command. The circuitry comprises two flip-flops, six two-input NAND gates (two of which are used as inverters) and an RC circuit. The original pulse train is supplied to a first two-input NAND gate which also receives a blocking signal derived from the "remove a pulse" command and which serves to block the passage of the pulse of the original pulse train which is to be removed. The output of this first NAND gate is fed to a second NAND gate, acting as an inverter, which provides the output pulse train from which the relevant pulse is removed. The blocking signal is derived from the "remove a pulse" command by way of two flip-flops, the first of which receives the "remove a pulse" command at its clock input and the second of which receives the uninverted output of the first flip-flop and, at its clock input, the original pulse train as inverted by a third NAND gate acting as an inverter. The second flip-flop delivers the blocking signal from its inverted output. The uninverted output of the second flip-flop and the original pulse train are supplied to a fourth NAND gate, the output of which is fed via an inverter (a fifth NAND gate acting as inverter) and the RC circuit to one input of a sixth NAND gate, the other input of which receives the output of the fourth NAND gate directly. The output of this sixth NAND gate is connected to CLEAR terminals of the two flip-flops.

The textbook "Halbleiter-Schaltungstechnik", U. Tietze, Ch. Schenk, 5th Edition, Springer Verlag, Berlin, Heidelberg, New York, 1980, pages 147 and 148 describes the link between "positive" logic (logic "1" = high voltage level) and "negative" logic (logic "1" = low voltage). A positive logic NOR gate is said to be equivalent to a negative logic NAND gate, and a positive logic OR gate is said to be equivalent to a negative logic AND gate.

According to the present invention there is provided a clock signal conversion circuit which receives a clock signal and a control signal and generates a converted clock signal, said clock signal conversion circuit comprising:
means for selectively masking said clock signal in dependence upon said control signal and outputting said converted clock signal;

a clocked D-type flip-flop, for holding said control signal in response to said clock signal and outputting a held control signal to said means for selectively masking said clock signal; and

set means being realized as gate means for generating a pulse-like set signal in response to said clock signal, said control signal and the inverted held control signal, as a result of time lag between a change in level of said clock signal and a change in level of said inverted held control signal, said flip-flop being forced to assume a predetermined state in response to said set signal.

An embodiment of the present invention can provide an improved clock signal conversion circuit which overcomes the problems associated with the conventional conversion circuit and which is easy to use.

An embodiment of the present invention provides a clock signal conversion circuit which receives a clock signal (an external clock signal) and a control signal and generates a converted clock signal (an internal clock signal), the clock signal conversion circuit comprising:
means for holding the control signal in response to the (external) clock signal and for outputting a held control signal; means for selectively masking the (external) clock signal in response to the held control signal to output the converted (internal) clock signal; and means for generating a set signal in response to the (external) clock signal, the control signal and the held control signal, the holding means being forced to assume a predetermined state in response to the set signal.

Thus, it is provided that the electric potential state or level of the control signal when the external clock signal is at one level, e.g. "L" level is not maintained in the holding means (not followed by the holding means), e.g. a flip-flop. Therefore, even if the control signal changes when the external clock signal is in "L" level, this change does not appear in the internal clock signal. Thus, the problem associated with the conventional clock signal conversion circuit is avoided.

Reference is made, by way of example to the accompanying drawings, in which:-

Fig. 1 is a schematic block diagram illustrating in a general way an embodiment of the present invention;

Fig. 2 is a schematic block diagram of the structure of a clock signal conversion circuit according to an embodiment of the present invention;

Fig. 3 is a timing diagram illustrating how a clock signal conversion circuit according to an embodiment of the present invention is operated when the cycle of the control signal Ct is longer than that of the external clock signal Ecp;

Fig. 4 is a timing diagram illustrating how a clock signal conversion circuit according to an embodiment of the present invention is operated when the cycle of the control signal Ct is shorter than that of the external clock signal Ecp;

Fig. 5 is a schematic block diagram of a pulse motor controller in which a conventional clock signal conversion circuit is employed;

Fig. 6 schematically illustrates the structure of the conventional clock signal conversion circuit; and

Figs. 7A and 7B are timing diagrams illustrating how the conventional clock signal conversion circuit is operated.

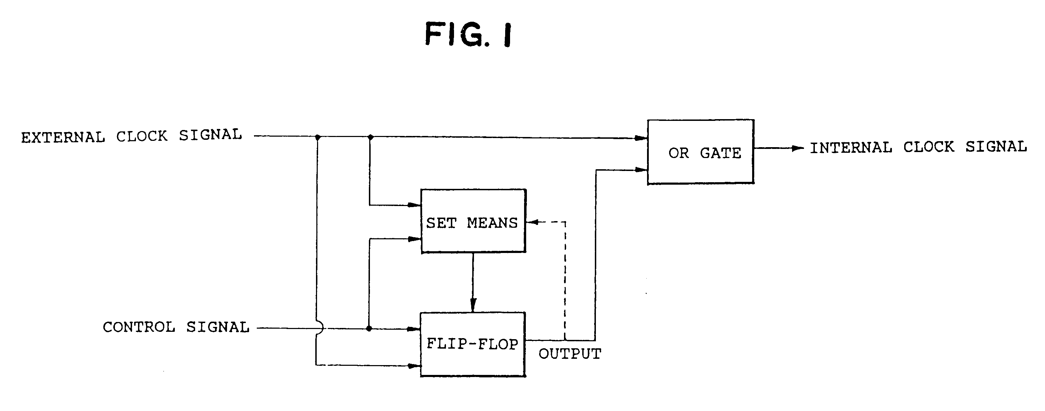

In the illustration provided by Fig. 1, a clock signal conversion circuit receives an external clock signal and a control signal, and provides a (converted) internal clock signal.

The circuit comprises a FLIP-FLOP as means for holding the control signal in response to the external clock signal. The flip-flop may be a D-type flip-flop, for instance a flip-flop circuit having a data input terminal for receiving the control signal, a clock input terminal for receiving the external clock signal, and an output terminal (OUTPUT) for outputting the held control signal, an inverted output terminal for outputting an inverted held control signal (indicated by a broken line), and a set terminal for receiving a set signal from SET MEANS, provided in the clock signal conversion circuit for generating the set signal. Means for masking the external clock signal in response to the held control signal, which means are operable to output the internal clock signal, comprise an OR-gate, arranged for receiving the clock signal and the held control signal and outputting the converted clock signal. The SET MEANS, for generating the set signal, comprise a NAND gate arranged for receiving the clock signal, the control signal and the inverted held control signal and is operable to output the set signal to a set terminal of the flip-flop.

This clock signal conversion circuit can be used whether the period of the external clock signal is smaller or larger than that of the control signal. The (external) clock signal may also be asynchronous with the control signal. The control signal may also be asynchronous with the control signal.

As indicated above, the electric potential state of the control signal, when the external signal is at "L" is not maintained in the flip-flop. Therefore, even if the control signal changes when the external clock signal is at "L" level, this change does not appear in the internal clock signal. Thus, the problem associated with the conventional clock signal conversion circuit is avoided.

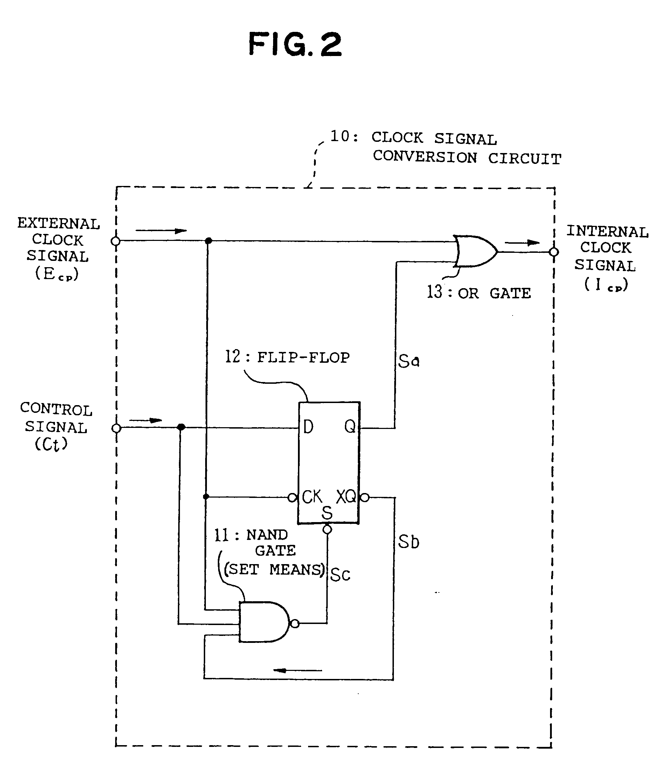

Referring to Fig. 2, there is shown an embodiment of a clock signal conversion circuit 10 in accordance with the present invention, illustrated in more detail. The clock signal conversion circuit 10 comprises a NAND gate 11, a flip-flop 12 with a forced set input S, and an OR gate 13.

The NAND gate 11 is constructed such that it outputs a forced set signal Sc, of "L" level, when an external clock signal Ecp and a control signal Ct are both at a first electric potential or level, for example, "H" level and when an output signal Sb from the flip-flop 12 is at a level representing a reset state of the flip-flop, for example "H" level. The NAND gate 11 therefore functions as set means. If the forced set signal Sc from the NAND gate 11 is input at "L" level into the flip-flop 12, the flip-flop 12 then shifts to a set state in which the electric potential state or level of the forced set signal Sc at that time is maintained. In addition, if, after the shift to the set state, the control signal Ct is at a second electric potential or level, for example "L" level, and the external clock signal Ecp falls from "H" level to "L" level, then the flip-flop 12 shifts to a reset state. In the set state, the flip-flop 12 outputs signals Sa (Sa = "H") and Sb (Sb = "L") from output terminals Q and XQ, respectively, and in the reset state, the flip-flop 12 outputs signals Sa (Sa = "L") and Sb (Sb = "H"). The OR gate 13 outputs an internal clock signal Icp in accordance with OR logic between the output signal Sa from the flip-flop 12 and the external clock signal Ecp. For instance, the internal clock signal Icp is maintained "H" when Sa = "H" and becomes Ecp = Icp when Sa = "L".

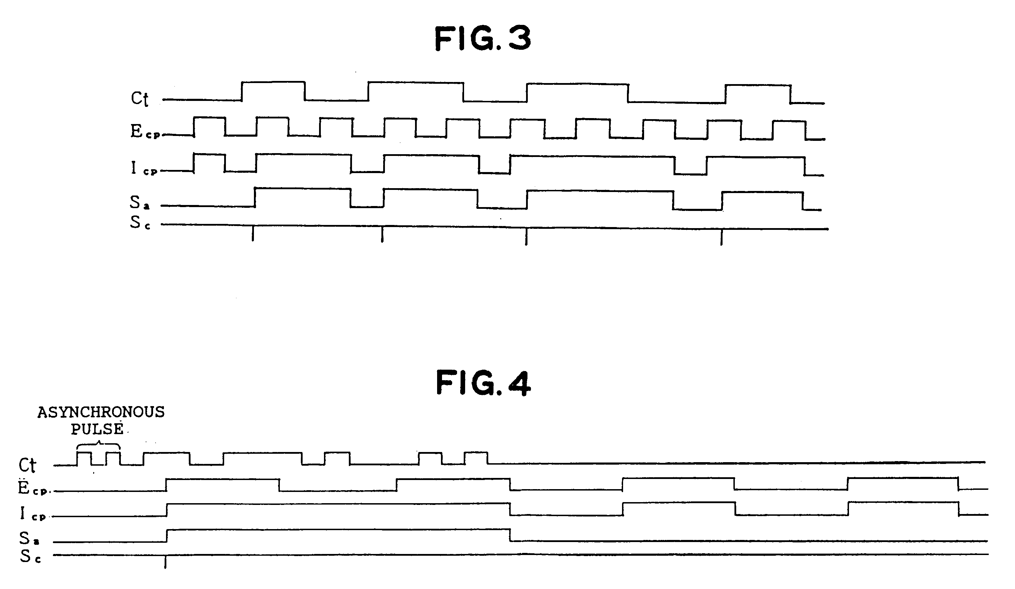

With the circuit structure as described above, a situation may be considered in which the cycle (time) of the control signal Ct is shorter than that of the external clock signal Icp, as shown in the timing diagram of Fig. 4. As previously stated, in such a case, with the conventional clock signal conversion circuit, there was the problem that changes in the control signal Ct occurring during an "L" level period of the external clock signal Ecp were carried through to and appeared in the internal clock signal Icp. If, now, the flip-flop 12 is in the reset state, the output signal Sb therefrom will be at "H" level. Therefore, when both the control signal Ct and the external clock signal Ecp are "H", the forced set signal Sc output from the NAND gate 11 becomes "L" and causes the flip-flop 12 to shift to the set state. In a period over which Ecp = "L", in which the above-described problem would arise with the conventional clock signal conversion circuit, the forced set signal Sc is maintained "H", and there is no change of state in the flip-flop 12. Therefore, even if, in a period over which Ecp = "L", asynchronous pulses appear in the control signal Ct, the flip-flop 12 continues to maintain Sa = "L" without being affected by the asynchronous pulses. As a result, the internal clock signal Icp is output at the same level as the external clock signal Ecp (in this case, "L" level), and the above-described problem is avoided.

There may also be considered a situation in which the cycle (time) of the control signal Ct is longer than that of the external clock signal Ecp. A timing diagram of such a case is shown in Fig. 3. As previously stated, the forced set signal Sc becomes "L" when the control signal Ct and the external clock signal Ecp are both "H" and when the flip-flop 12 is in the reset state (that is, Sb = "H"). With Sc = "L", the flip-flop 12, previously in the reset state, shifts to the set state and changes its output signals Sa from "L" to "H" and Sb from "H" to "L". Consequently, the internal clock signal Icp is fixed at "H" level during Sb = "H". Thereafter, if the external clock signal Ecp falls from "H" to "L" whilst Ct = "L", the flip-flop 12 returns to the reset state, so that the signal Sa is reversed from "H" to "L" and the signal Sb is reversed from "L" to "H". At this time, the internal clock signal Icp falls, in synchronisation with the fall time of the external clock signal Ecp. That is to say, if the external clock signal Ecp rises while the control signal is at "H" level, then the clock signal Icp also rises in synchronisation with the rise time of the external clock signal Ecp, and thereafter, if the external clock signal Ecp falls while the control signal Ct is at "L" level, then the internal clock signal Icp also falls in synchronisation with the fall time of the Ecp. Consequently, by suitably setting the length of the "H" and "L" levels, an internal clock signal can be produced and output which is synchronised with the external clock signal and is controlled by the length or duration of the "H" and "L" levels. It should be noted that, in a case in which the cycle (time) of the control signal is longer than that of the external clock signal Ecp, if the NAND gate 11 is not provided in the structure as shown in Fig. 2, there is the possibility that unnecessary pulses might appear in the internal clock signal Icp. These unnecessary pulses can also be eliminated by the Fig. 2 structure. Consequently, an embodiment of the present invention is particularly advantageous in a case in which the cycle (time) of the control signal is longer than that of the external clock signal Ecp.

An embodiment of the present invention provides a clock signal conversion circuit which receives a clock signal and a control signal and generates a converted clock signal, the clock signal conversion circuit comprising: means for holding the control signal in response to the clock signal and outputting a held control signal; means for selectively masking the clock signal in response to the held control signal and outputting the converted clock signal; and means for generating a set signal in response to the clock signal, the control signal and the held control signal, the holding means being forced to assume a predetermined state in response to the set signal.

## Claims

1. A clock signal conversion circuit which receives a clock signal (Ecp) and a control signal (Ct) and generates a converted clock signal (Icp), said clock signal conversion circuit comprising:

   means (13) for selectively masking said clock signal (Ecp) in dependence upon said control signal (Ct) and outputting said converted clock signal (Icp);

   a clocked D-type flip-flop (12), for holding said control signal (Ct) in response to said clock signal (Ecp) and outputting a held control signal (Sa) to said means (13) for selectively masking said clock signal (Ecp); and

   set means (11) being realized as gate means for generating a pulse-like set signal (Sc) in response to said clock signal (Ecp), said control signal (Ct) and the inverted held control signal ($\overline{Sa}$, Sb), as a result of time lag between a change in level of said clock signal (Ecp) and a change in level of said inverted held control signal ($\overline{Sa}$, Sb), said flip-flop (12) being forced to assume a predetermined state in response to said set signal (Sc).

2. A clock signal conversion circuit according to claim 1, wherein said D-type flip-flop comprises a flip-flop circuit having a data input terminal (D) for receiving said control signal (Ct), a clock input terminal (CK) for receiving said clock signal (Ecp), an output terminal (Q) for outputting said held control signal (Sa), an inverted output terminal (XQ) for outputting said inverted held control signal ($\overline{Sa}$, Sb), and a set terminal (S) for receiving said set signal (Sc).

3. A clock signal conversion circuit according to claim 1 or 2, wherein said masking means (13) comprises an OR-gate for receiving said clock signal (Ecp) and said held control signal (Sa) and outputting said converted clock signal (Icp).

4. A clock signal conversion circuit according to claim 1, 2 or 3, wherein said set means (11) comprises a NAND gate for receiving said clock signal (Ecp), said control signal (Ct) and said inverted held control signal ($\overline{Sa}$, Sb) and outputting said set signal (Sc) to said set terminal (S) of said flip-flop (12).

5. A clock signal conversion circuit according to any preceding claim, wherein the period of said clock signal (Ecp) is smaller than that of said control signal (Ct).

6. A clock signal conversion circuit according to claim 1, wherein said control signal is asynchronous with said clock signal.

## Patentansprüche

1. Taktsignalumsetzschaltung, die ein Taktsignal (Ecp) sowie ein Steuersignal (Ct) empfängt und ein umgesetztes Taktsignal (Icp) erzeugt, wobei die Taktsignalumsetzschaltung umfaßt:

   eine Einrichtung (13), geeignet zum selektiven Maskieren des Taktsignals (Ecp) abhängig vom Steuersignal (Ct) und zum Ausgeben des umgesetzten Steuersignals (Icp);

   ein getaktetes D-Flip-Flop (12), geeignet zum Speichern des Steuersignals (Ct) als Reaktion auf das Taktsignal (Ecp) und zur Ausgabe eines gespeicherten Steuersignals (Sa) an die Einrichtung (13) zum selektiven Maskieren des Taktsignals (Ecp); und

   eine als Gattereinrichtung ausgeführte Setzeinrichtung (11), geeignet zum Erzeugen eines pulsähnlichen Setzsignals (Sc) als Reaktion auf das Taktsignal (Ecp), das Steuersignal (Ct) und das invertierte, gespeicherte Steuersignal ($\overline{Sa}$, Sb) und als Ergebnis der Zeitverschiebung zwischen einer Pegeländerung des Steuersignals (Ecp) und einer Pegeländerung des invertierten, gespeicherten Steuersignals ($\overline{Sa}$, Sb), wobei das Flip-Flop (12) gezwungen wird, als Reaktion auf das Setzsignal (Sc) einen vorbestimmten Zustand anzunehmen.

2. Taktsignalumsetzschaltung nach Anspruch 1, wobei das D-Flip-Flop enthält eine Flip-Flop-Schaltung mit einem Dateneingangsanschluß (D) zum Empfangen des Steuersignals (Ct); einen Takteingangsanschluß (CK) zum Empfangen des Taktsignals (Ecp); einen Ausgangsanschluß (Q) zum Ausgeben des gespeicherten Steuersignals (Sa); einen invertierten Ausgangsanschluß (XQ) zum Ausgeben des invertierten, gespeicherten Steuersignals ($\overline{Sa}$, Sb); und einen Setzanschluß (S) zum Empfangen des Setzsignals (Sc).

3. Taktsignalumsetzschaltung nach Anspruch 1 oder 2, wobei die Maskiereinrichtung (13) ein ODER-Gatter zum Empfangen des Taktsignals (Ecp) und des gespeicherten Steuersignals (Sa) und zum Ausgeben des umgesetzten Taktsignals (Icp) enthält.

4. Taktsignalumsetzschaltung nach Anspruch 1, 2 oder 3, wobei die Setzeinrichtung (11) ein NAND-Gatter zum Empfangen des Taktsignals (Ecp), des Steuersignals (Ct) und des invertierten, gespeicherten Steuersignals ($\overline{Sa}$, Sb) sowie zum Ausgeben des Setzsignals (Sc) auf den Anschluß (S) des Flip-Flops (12) enthält.

5. Taktsignalumsetzschaltung nach irgendeinem vorhergehenden Anspruch, wobei die Periodendauer des Taktsignals (Ecp) kleiner ist als die des Steuersignals (Ct).

6. Taktsignalumsetzschaltung nach Anspruch 1, wobei das Steuersignal nicht mit dem Taktsignal synchronisiert ist.

**Revendications**

1. Circuit de conversion de signal d'horloge qui reçoit un signal d'horloge (Ecp) et un signal de commande (Ct), et qui génère un signal d'horloge converti (Icp), ledit circuit de conversion de signal d'horloge comprenant :
   - des moyens (13) pour masquer sélectivement ledit signal d'horloge (Ecp) en fonction dudit signal de commande (Ct) et pour produire en sortie ledit signal d'horloge converti (Icp) ;
   - une bascule (12) de type D synchronisée, pour maintenir ledit signal de commande (Ct) en réponse audit signal d'horloge (Ecp) et pour produire un signal de commande maintenu (Sa) en sortie sur lesdits moyens (13) pour masquer sélectivement ledit signal d'horloge (Ecp) ;
   et
   des moyens (11) de mise à "1", réalisés sous forme de portes, pour générer un signal (Sc) de mise à "1" de forme impulsionnelle en réponse audit signal d'horloge (Ecp), audit signal de commande (Ct) et audit signal d'horloge inversé et maintenu ($\overline{Sa}$, Sb), du fait du retard temporel entre le changement de niveau dudit signal d'horloge (Ecp) et du changement de niveau dudit signal de commande maintenu et inversé ($\overline{Sa}$, Sb), ladite bascule (12) étant forcée à prendre un état prédéterminé en réponse audit signal (Sc) de mise à "1".

2. Circuit de conversion de signal d'horloge selon la revendication 1, dans lequel ladite bascule de type D comporte un circuit de bascule dont une borne d'entrée de données (D) reçoit ledit signal de commande (Ct), une borne d'entrée d'horloge (CK) reçoit ledit signal d'horloge (Ecp), une borne de sortie (Q) produit en sortie ledit signal de commande maintenu (Sa), une borne de sortie inverseuse (XQ) produit en sortie ledit signal de commande maintenu et inversé ($\overline{Sa}$, Sb) et une borne de mise à "1" (S) reçoit ledit signal de mise à "1" (Sc).

3. Circuit de conversion de signal d'horloge selon la revendication 1 ou 2, dans lequel lesdits moyens de masquage (13) comportent une porte OU pour recevoir ledit signal d'horloge (Ecp) et ledit signal de commande maintenu (Sa) et pour produire en sortie ledit signal d'horloge converti (Icp).

4. Circuit de conversion de signal d'horloge selon la revendication 1, 2 ou 3, dans lequel les dits moyens de mise à "1" comportent une porte NON ET pour recevoir ledit signal d'horloge (Ecp), ledit signal de commande (Ct) et ledit signal de commande maintenu et inversé ($\overline{Sa}$, Sb) et pour produire en sortie ledit signal de mise à "1" (Sc) sur ladite borne de mise à "1" (S) de ladite bascule (12).

5. Circuit de conversion de signal d'horloge selon l'une quelconque des revendications précédentes, dans lequel la période du dit signal d'horloge (Ecp) est plus petite que celle du dit signal de commande (Ct).

6. Circuit de conversion de signal d'horloge selon la revendication 1, dans lequel ledit signal de commande est asynchrone par rapport audit signal d'horloge.

# FIG. 1

EXTERNAL CLOCK SIGNAL ⟶ ... ⟶ OR GATE ⟶ INTERNAL CLOCK SIGNAL

SET MEANS

CONTROL SIGNAL ⟶

FLIP-FLOP — OUTPUT

EP 0 382 233 B1

# FIG.2

10: CLOCK SIGNAL CONVERSION CIRCUIT

EXTERNAL CLOCK SIGNAL ($E_{cp}$)

INTERNAL CLOCK SIGNAL ($I_{cp}$)

13: OR GATE

12: FLIP-FLOP

Sa

CONTROL SIGNAL ($C_t$)

D    Q

CK   XQ
  S

Sb

11: NAND GATE (SET MEANS)

Sc

8

## FIG.3

Ct

$E_{cp}$

$I_{cp}$

$S_a$

$S_c$

## FIG.4

ASYNCHRONOUS
PULSE

Ct

$E_{cp}$

$I_{cp}$

$S_a$

$S_c$

**FIG.5**

**FIG.6**
**PRIOR ART**

OR GATE

# FIG. 7 A
## PRIOR ART

$E_{cp}$

$Ct$      "H"      "L"      "H"

$I_{cp}$

# FIG. 7 B
## PRIOR ART

$E_{cp}$      "L"

$Ct$    (a)    (b)

$I_{cp}$

ASYNCHRONOUS PULSE
(UNNECESSARY)